# EUROPEAN PATENT APPLICATION

(11) **EP 4 790 887 A1**
(43) Date of publication of application: **12.08.2026**
(21) Application number: 25156932.3
(22) Date of filing: 10.02.2025
(51) Int. Cl.: H02N 2/06, H02N 2/02, G03F 7/00

(54) **PIEZO ACTUATOR DAMPING**

(71) Applicant: ASML Netherlands B.V., 5500 AH Veldhoven (NL)
(72) Inventor: PRATTAMA, Hebert Satria Juvi, 5500 AH Veldhoven (NL); JANSEN, Bas, 5500 AH Veldhoven (NL); BUTLER, Hans, 5500 AH Veldhoven (NL)
(74) Representative: ASML Netherlands B.V.

(57) **Abstract**

A piezo motor system comprises a first piezo (P1), a second piezo (P2), and a controller (CON). The first piezo (P1) is configured to exert a first piezo force in a first direction. The second piezo (P2) is configured to exert a second piezo force in a second direction. The second direction is different from the first direction. One of the first piezo (P1) and the second piezo (P2) is configured to actuate the other one of the first piezo (P1) and the second piezo (P2) and the other one of the first piezo (P1) and the second piezo (P2) is configured to actuate the object (OBJ).

The controller (CON) is configured to detect from the first piezo (P1) an electric signal representative of a force on the first piezo (P1) in the second direction, and apply damping control for the piezo motor system using the second piezo (P2) based on the detected electric signal.

## Description

### FIELD

The present invention relates to a piezo motor system for positioning an object, a projection system comprising said piezo motor system, an exposure apparatus, a method of controlling a piezo motor system and a manufacturing method.

### BACKGROUND

In semiconductor device manufacturing processes, apparatuses can be used to process and/or assess objects such as a substrate or a patterning device. An example of such an apparatus is an exposure apparatus used to generate interactions between a radiation, for example an electromagnetic radiation or a charged-particle radiation, with a substrate. Other examples of such apparatuses are a deposition apparatus, an etching apparatus, and a die-bonding apparatus. A lithographic apparatus and an assessment apparatus are examples of an exposure apparatus. A lithographic apparatus may use an electromagnetic radiation or a charged-particle radiation to form a pattern onto a layer of radiation-sensitive material, for example a layer of photo resist, provided on a substrate. Examples of a lithographic apparatus are a deep ultraviolet (DUV) lithographic apparatus and an extreme ultraviolet (EUV) lithographic apparatus. An assessment apparatus may form interaction products resulting from interaction of an electromagnetic radiation or charged-particle radiation with an object such as a substrate or a patterning device. An inspection apparatus and a metrology apparatus are examples of such assessment apparatuses and may be used to detect defects such as particles or measure a parameter of interest such as a critical dimension, for example.

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

In the lithographic apparatus, piezo actuators may be comprised. In the lithographic apparatus, the piezo actuators may be used to position an object, such as an optical element of a projection system of the lithographic apparatus.

The term piezo is to be understood as referring to a material exhibiting a piezoelectric effect and/or a reverse piezoelectric effect. The piezoelectric effect may result from the linear electromechanical interaction between mechanical and electrical states in crystalline materials with no inversion symmetry. The piezoelectric effect may be a reversible process: materials exhibiting the piezoelectric effect also exhibit the reverse piezoelectric effect, the internal generation of a mechanical strain resulting from an applied electric field.

Active damping control may be used to control a damping of the object. Thereto, use may be made of the reversible properties of the piezoelectric effect: when subject to mechanical stress, the piezo actuator may output an electrical signal which may be used as an input signal to control a damping of the object.

This so called piezo self-sensing may provide a way to measure external force that acts on a piezo which is also used as an actuator. This may be done in a Wheatstone bridge configuration which may require an additional loadless piezo. The measured external force may then be used for damping control using the same piezo. Using the self-sensing of a piezo as a feedback to itself may be sensitive to the manufacturing tolerance of the components in the Wheatstone bridge.

A stepper motor may be provided for positioning a driving rod forming part of or connected with the object with an extended positioning range. A stepper motor may require 2 types of piezos, shear and clamp. The shear piezo may be responsible to actuate the driving rod, while the clamp piezo may clamp the shear piezo to the driving rod. The number of shear and clamp piezo in a stepper motor may vary depending on the implementation. A throughput performance of the stepper motor may be limited due to system excitation during the "stepping" action. Currently, a long settling time may be observed.

### SUMMARY

Considering the above, it is an object of the invention to provide a piezo motor system enabling a fast settling time.

According to an embodiment of the invention, there is provided a piezo motor system for positioning an object, the piezo motor system comprising a first piezo, a second piezo, and a controller, wherein
- the first piezo is configured to exert a first piezo force in a first direction,
- the second piezo is configured to exert a second piezo force in a second direction, the second direction is different from the first direction, one of the first piezo and the second piezo is configured to actuate the other one of the first piezo and the second piezo and the other one of the first piezo and the second piezo is configured to actuate the object, and
- the controller is configured to
   - detect from the first piezo an electric signal representative of a force on the first piezo in the second direction, and
   - apply damping control for the piezo motor system using the second piezo based on the detected electric signal.

According to a further embodiment of the invention, there is provided a projection system for an exposure apparatus, comprising the piezo motor system according to the invention.

According to a yet further embodiment of the invention, there is provided an exposure apparatus comprising the piezo motor system according to the invention or the projection system according to the invention.

According to a still further embodiment of the invention, there is provided a method of controlling a piezo motor system comprising for positioning an object, the piezo motor system comprising a first piezo and a second piezo, wherein
- the first piezo is configured to exert a force in a first direction,
- the second piezo is configured to exert a force in a second direction,
   wherein the second direction is different from the first direction,
   wherein one of the first piezo and the second piezo is configured to actuate the other one of the first piezo and the second piezo and the other one of the first piezo and the second piezo is configured to actuate the object, and
- wherein the method comprises
   - detecting from the first piezo an electric signal representative of a force in the second direction, and
   - applying damping control for the piezo motor system using the second piezo based on the detected electric signal.

According to a yet still further embodiment of the invention, there is provided a manufacturing method for manufacturing a semiconductor item, comprising exposing a substrate to a radiation using the exposure apparatus according to the invention, developing the exposed substrate, and manufacturing a semiconductor item from the developed substrate.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus according to an embodiment of the invention;
- Figure 2 depicts a detailed view of a part of the lithographic apparatus of Figure 1;
- Figure 3 schematically depicts a position control system as part of a positioning system according to an embodiment of the invention;
- Figure 4 depicts a schematic view of a motor system according to an embodiment;
- Figure 5A - 5D depict piezo actuators as may be comprised in the motor system;
- Figure 6 depicts a more detailed view of the controller as may be comprised in the motor system;
- Figure 7 depicts another embodiment of the piezo actuators as may be comprised in the motor system; and
- Figure 8 depicts time and frequency diagrams to illustrate a performance of the motor system.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

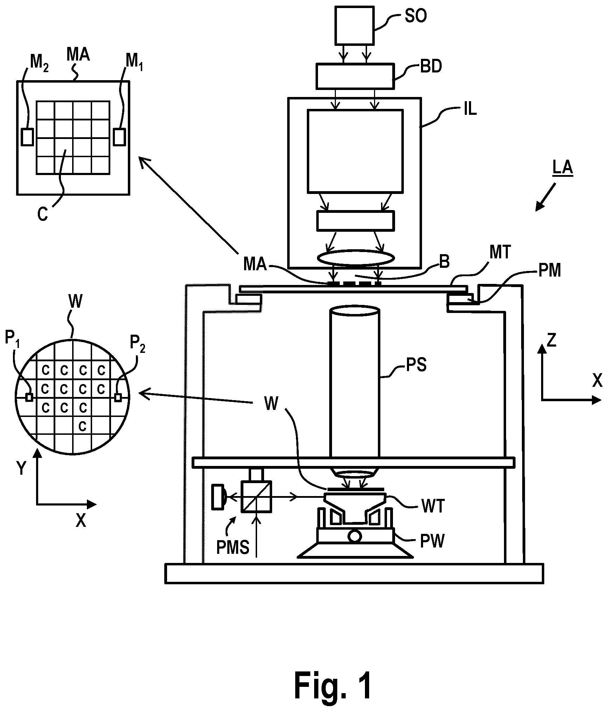

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

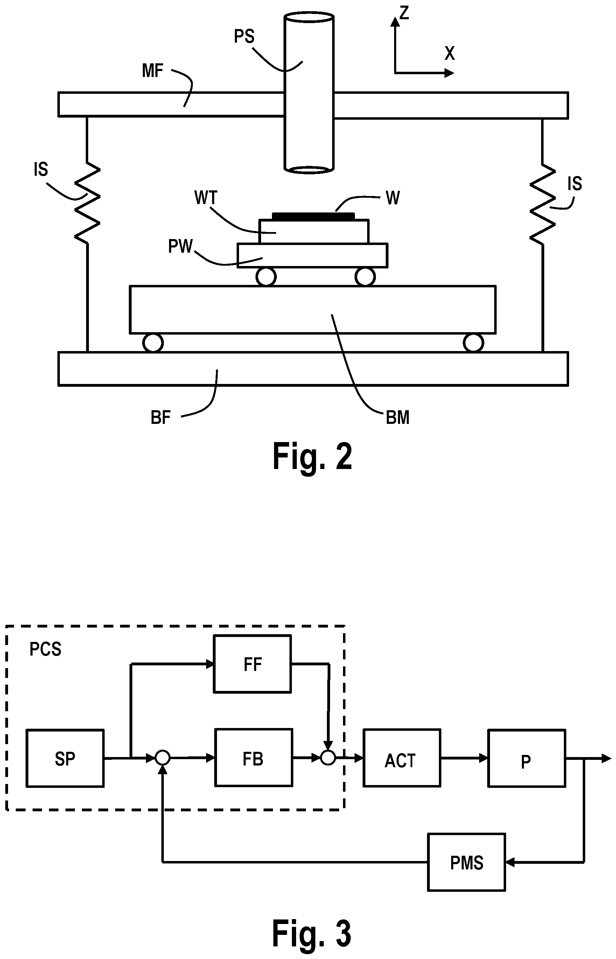

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor, a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

The position measurement system PMS may comprise an encoder system. An encoder system is known from for example, United States patent application US2007/0058173A1, filed on September 7, 2006, hereby incorporated by reference. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example, +1^{st} order, -1^{st} order, +2^{nd} order and -2^{nd} order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads is arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electro-magnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.

The lithographic apparatus LA comprises a position control system PCS as schematically depicted in Figure 3. The position control system PCS comprises a setpoint generator SP, a feedforward controller FF and a feedback controller FB. The position control system PCS provides a drive signal to the actuator ACT. The actuator ACT may be the actuator of the first positioner PM or the second positioner PW. The actuator ACT drives the plant P, which may comprise the substrate support WT or the mask support MT. An output of the plant P is a position quantity such as position or velocity or acceleration. The position quantity is measured with the position measurement system PMS. The position measurement system PMS generates a signal, which is a position signal representative of the position quantity of the plant P. The setpoint generator SP generates a signal, which is a reference signal representative of a desired position quantity of the plant P. For example, the reference signal represents a desired trajectory of the substrate support WT. A difference between the reference signal and the position signal forms an input for the feedback controller FB. Based on the input, the feedback controller FB provides at least part of the drive signal for the actuator ACT. The reference signal may form an input for the feedforward controller FF. Based on the input, the feedforward controller FF provides at least part of the drive signal for the actuator ACT. The feedforward FF may make use of information about dynamical characteristics of the plant P, such as mass, stiffness, resonance modes and eigenfrequencies.

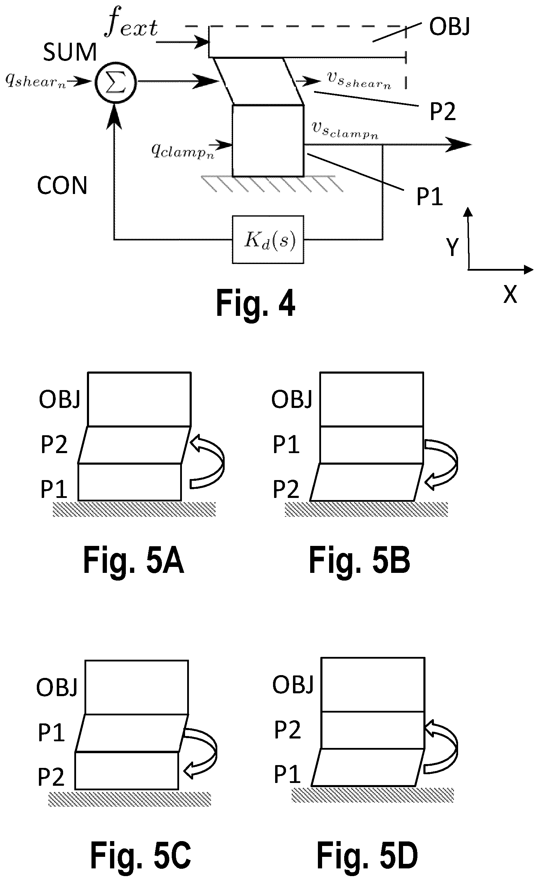

Figure 4 depicts a highly schematic view of a motor system according to an embodiment. The motor system is configured to position an object OBJ and comprises a first piezo P1, a second piezo P2 and a controller CON. The first piezo is configured to exert a first piezo force in a first direction, The second piezo is configured to exert a second piezo force in a second direction, The second direction is different from the first direction. In the depicted embodiment, the first piezo P1 is configured to generate a force in the Y-direction, i.e. towards the object so as to enable to clamp the object. In the depicted embodiment, the second piezo is configured to generate a force in the X-direction i.e. along a surface of the object. Thus, in the present example, the first direction of the first piezo is perpendicular to the second direction of the second piezo.

The first piezo and the second piezo may be stacked. One of the first and second piezos is configured to actuate the other one of the first and second piezos, which is in turn configured to actuate the object. For example, in the present embodiment, the first piezo is configured to actuate the second piezo and the second piezo is configured to actuate the object. Thus, in case the first piezo exerts a clamping force (in the present example: in Y direction) to clamp the second piezo against the object, the second piezo may exert a force to move the object, in the present example of the X-direction. The stack of the first and second piezos may be configured to actuate the object relative to a substantially stationary reference, such as a frame. Alternatively, the stack of the first and second piezos may be configured to actuate the object relative to a second movable object.

A part of the controller CON is depicted in Figure 4. The controller is configured to detect from the first piezo an electric signal representative of a force on the first piezo in the second direction, i.e. in the present example in the X-direction. Thus, in the present example, the controller is configured to detect from the first piezo, i.e. in the present example the clamping piezo, a shear force on the clamping piezo. The controller is further configured to drive the second piezo using the detected electrical signal from the first piezo. Thus, in the present example, the controller uses the shear force measured from the clamping piezo to generate a shear damping signal which shear damping signal is provided to the shear piezo. In more general terms, the controller uses the electrical signal representative of the force on the first piezo in the second direction to apply damping control to the second piezo based on the detected electrical signal. The electric signal may be a piezo crystal voltage or a piezo charge signal of the first piezo.

The inventors of the present patent application have realized that, in the case of two piezos, whereby one of the piezos acts on the other one of the piezos, which in turn acts on the object, and whereby the piezos are configured to exert forces in different directions, the damping in the second direction may be provided by damping control of the second piezo (configured to generate the force in the second direction) on the basis of an electrical signal derived from the first piezo (configured to generate the force in the first direction), the electrical signal representing the force on the first piezo in the second direction. For example, in case the first piezo comprises a clamping piezo and the second piezo comprises a shear piezo, an electrical signal representative of the shear force is detected from the clamping piezo, the electrical signal being used for damping control of the shear piezo. Thus, although the first piezo is configured to generate a force in the first direction, the inventors have realized that the first piezo may still generate a signal when excited in the second direction, i.e. when subject to a force in the second direction. This signal is used to damp the vibrations of the object in the second direction. Accordingly, in the present example, although the clamp piezo is configured to generate a clamping force, the clamp piezo may still generate a signal when excited in the shear direction, i.e. when subject to a force in the shear direction. This signal is used to damp the vibrations of the object in the shear direction.

As shown in Figure 4, the controller CON comprises an filter K_{d}(s) configured to filter the electrical signal provided by the first piezo. The filter K_{d}(s) may for example comprise a bandpass filter. The controller further comprises a summation SUM configured to sum the filtered electrical signal and a signal representative of the setpoint excitation of the second piezo, i.e. in the present example the shear charge qₛₕₑₐᵣ , the result of the summation being supplied to the second piezo, in the present example the shear piezo, to generate the shear force. The summation provides for a combination of the desired excitation of the first piezo and a damping signal formed by the filtered electrical signal obtained from the second piezo.

Figure 5A - 5D highly schematically depict arrangements of the first and second piezo as may be comprised in embodiments of the invention. Each arrangement comprises the first piezo P1, the second piezo P2 and the object OBJ.

The arrangement as schematically depicted in Figure 5A substantially corresponds to the arrangement of the first and second piezo is Figure 4, namely in that the first piezo P1 actuates on the second piezo P2, and the second piezo actuates on the object. Thus, the first piezo mediately actuates on the object via the second piezo. The first piezo may be a clamping piezo configured to clamp the object (mediately via the second piezo). The second piezo may be a shear piezo configured to exert a shear force on the object. As symbolized by the arrow from the first piezo to the second piezo, the electrical signal from the first piezo responsive to a force on the first piezo in the second direction (the shear force), is used for damping control of the second piezo in the second direction (the shear direction).

Figure 5B depicts an alternative arrangement of the piezos, wherein the second piezo P2 actuates on the first piezo P1, and the first piezo actuates on the object. Thus, the second piezo mediately actuates on the object via the first piezo. Likewise to Figure 5A, the first piezo may be a clamping piezo configured to clamp the object (immediately). The second piezo may be a shear piezo configured to exert a shear force on the object (mediately via the first piezo). As symbolized by the arrow from the first piezo to the second piezo, the electrical signal from the first piezo responsive to a force on the first piezo in the second direction (the shear force), is used for damping control of the second piezo in the second direction (the shear direction).

Figure 5C depicts an alternative arrangement of the piezos, wherein the second piezo P2 actuates on the first piezo P1, and the first piezo actuates on the object. Thus, the second piezo mediately actuates on the object via the first piezo. In the present example, the first piezo may be a shear piezo configured to exert a shear force on the object (immediately). The second piezo may be a clamping piezo configured to exert a clamping force on the object (mediately via the first piezo). As symbolized by the arrow from the first piezo to the second piezo, the electrical signal from the first piezo responsive to a force on the first piezo in the second direction (the clamping force), is used for damping control of the second piezo in the second direction (the clamping direction).

Figure 5D depicts an alternative arrangement of the piezos, wherein the first piezo P1 actuates on the second piezo P2, and the second piezo actuates on the object. Thus, the first piezo mediately actuates on the object via the second piezo. The first piezo may be a shear piezo configured to exert a shear force on the object (mediately via the second piezo). The second piezo may be a clamping piezo configured to exert a clamping force on the object. As symbolized by the arrow from the first piezo to the second piezo, the electrical signal from the first piezo responsive to a force on the first piezo in the second direction (the clamping force), is used for damping control of the second piezo in the second direction (the clamping direction).

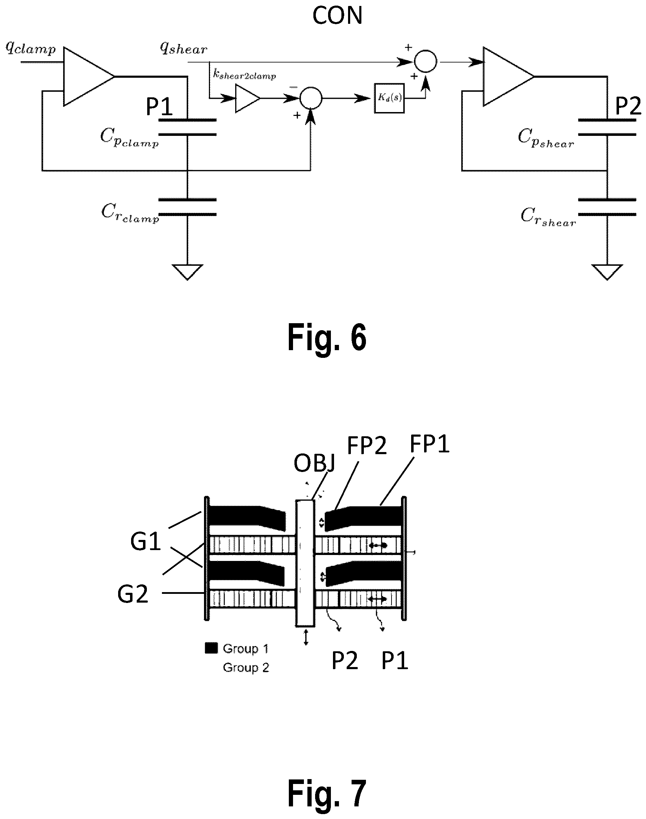

Figure 6 highly schematically depicts an embodiment of the controller. The controller is configured to control the shear piezo and to control the clamp piezo. The clamp piezo C_{pclamp} and a clamp reference capacitance C_{rclamp} are arranged in a feedback path of a clamping piezo charge amplifier. The clamping piezo charge amplifier is provided with a clamping piezo charge setpoint signal q_{clamp}. The shear piezo Cₚₛₕₑₐᵣ and a shear piezo reference capacitance Cᵣₛₕₑₐᵣ are arranged in a feedback path of a shear piezo charge amplifier. The shear piezo charge amplifier is provided with a shear piezo charge setpoint signal qₛₕₑₐᵣ. The clamp piezo forms an example of the first piezo while the shear piezo forms an example of the second piezo.

According to the invention, an electrical signal from the first piezo is used to provide damping control of the second piezo. Accordingly, as depicted in Figure 6, the shear piezo charge setpoint signal qₛₕₑₐᵣ is amplified by a shear to clamp amplification ratio, k_{shear2clamp}, which is subtracted from an electrical signal from the clamping piezo charge amplifier. A resulting damping signal is added to the shear piezo charge setpoint signal qₛₕₑₐᵣ , the combined charge setpoint signal being provided as setpoint input to the shear piezo charge amplifier.

When using the clamp piezo for the self-sensing, a Wheatstone bridge to damp the shear may be omitted. When the shear is actuated, the clamp may typically stand still. As the clamp may be unactuated and the force-induced charge may only come from the shear group, the bridge may not be required.

Figure 7 depicts a part of a motor system according to an embodiment. The motor system comprises a plurality of first and second piezos configured to exert a force on the object, the first and second piezos are assigned to a first group and a second group. The first piezos P1 and second piezos P2 are assigned to the first group and the further first piezos FP1 and further second piezos FP2 are assigned to the second group. The first piezos and the further first piezos may be clamp piezos while the second piezos and the further second piezos may be shear piezos. The piezos of the first and second groups in turn interact with the object, as follows:

In a first part of a motor cycle time, the first (clamp) piezos of the first group are driven to clamp the object. Then, as the clamp piezos of the first group clamp the object, the second (shear) piezos of the first group are driven to exert a shear force on the object to provide a shear movement of the object. In the first part of the motor cycle time, the further first (clamp) piezos of the second group are driven to release the object.

In a second part of a motor cycle time, the further first (clamp) piezos of the second group are driven to clamp the object. Then, as the clamp piezos of the second group clamp the object, the further second (shear) piezos of the second group are driven to exert a shear force on the object to provide a shear movement of the object. In the second part of the motor cycle time, the first (clamp) piezos of the first group are driven to release the object.

Thus, in the first part of the motor cycle time, the first and second piezos of the first group interact with the object while in the second part of the motor cycle time, the further first and second piezos of the second group interact with the object. By in turn driving the first group of piezos and the second group of piezos to interact with the object, a stepper motor as shown in Figure 7 may be provided.

As the clamp piezos of the first group clamp the object, a settling time may be required to be taken into account, to enable damping of the first and second piezos, before driving the shear piezos of the first group to ecert a shear force on the object. For example, the settling time may be required for damping of the first and second piezos in the shear direction.

The damping control according to the present invention may enable to enhance a damping control of the first and second piezos when interacting with the object. The enhanced damping control may enable to reduct a settling time in the first part and the second part of the motor cycle time, i.e. each time the first and second piezos of the first group interact with the object and each time the first and second piezos of the second group interact with the object. Due to the faster settling time, the first and second parts of the motor cycle time may each be reduced in time, enabling to increase an effective operating rate of the motor system, e.g. an effective time between stepping movements of the object by the motor system. A similar damping control may be provided for the further first piezos and the further second piezos.

It is noted that alternative embodiments of the motor system comprising at least the first group and the second group of piezos may be provided, which may make use of a different motor cycle. For example, in an alternative embodiment. the shear legs are repositioned, for example from a maximum position, back to neutral / zero position, without movement of the object. In a further alternative embodiment, three or more groups of first and second piezos may be provided.

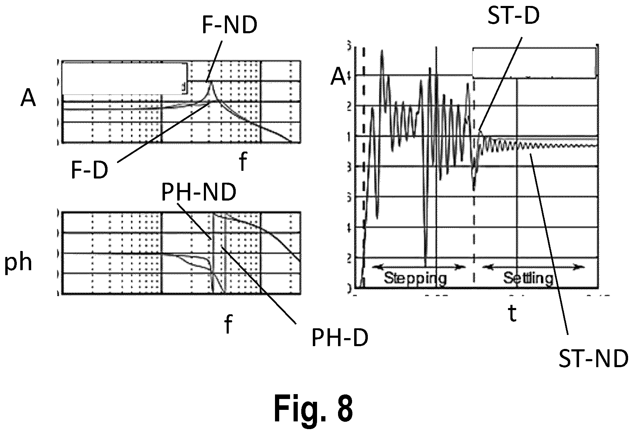

The enhanced damping control is illustrated with reference to Figure 8. Figure 8, left side, depicts a frequency response (amplitude A in the top graph and phase ph in the bottom graph against frequency f along the horizontal axis) of the first and second piezos of either group when interacting with the object. Frequency response with damping control F-D and frequency response without damping control F-ND are depicted. Phase with damping control PH-D and phase without damping control PH-ND are depicted. Without damping control, a resonance peak is observed. Similarly, Figure 8, right side, depicts a time response t of clamping and clamping and settling time. As seen in the time response depicting amplitude A on the vertical axis and time t on the horizontal axis, once the stepping action has been performed, settling takes place. As observed from the time response, the damping control according to the present invention may enable to reduce a settling time period. Settling time ST-D with closed loop damping in accordance with the present invention and settling time ST-ND without closed loop damping are depicted in Figure 8. An excitation of a vibration in the shear mode may be measured by the clamp piezos of the group that is actuated to interact with the object, the electric signal representative of a force on the clamp piezo in the shear direction is detect from the clamp piezo, and damping control for the piezo motor system is applied using the shear piezo of the group that is actuated based on the detected electric signal.

In an embodiment, the electric signal is a piezo crystal voltage or a piezo charge signal of the first piezo.

In an embodiment, the controller is configured to derive a damping control signal from the electric signal and to add the damping control signal from the first piezo to an actuation signal of the second piezo, an example of which being schematically depicted in Figure 4 as well as Figure 7. By adding the damping control signal to the actuation signal of the second piezo, actuation of the second piezo and damping by the second piezo may be performed simultaneously.

In an embodiment, the controller is configured to apply damping control for the piezo motor system using the second piezo. The second piezo may be driven to control damping. As the electric signal obtained from the first piezo is representative of force in the second direction, the second piezo may be used for effective damping.

In an embodiment, the controller is configured to control the second piezo according to a setpoint signal and to combine the setpoint signal with the electric signal. The damping control derived from the electric signal may accordingly be combined with the setpoint of the second piezo, hence enabling to perform damping control while operating the second piezo.

In an embodiment, the second direction is perpendicular to the first direction. For example, one of the first and second piezos may comprise a clamp piezo while the other one of the first and second piezos may comprise a shear piezo. The shear direction may be perpendicular to the clamp direction. In alternative embodiments, the first and second directions may be at a different angle relative to each other, for example an angle in a range between 45 degrees and 90 degrees.

In an embodiment, the first piezo comprises a clamp piezo and wherein the first piezo force in the first direction comprises a clamping force. In an embodiment, the second piezo comprises a shear piezo and wherein the second piezo force in the second direction comprises a shear force. Alternatively, the second piezo may comprise any other piezo configured to actuate in the second direction.

In an embodiment, the first piezo is configured to actuate the second piezo and wherein the second piezo is configured to actuate the object. The inventors have devised that a sensitivity of the clamping piezo to measure shear force is sufficiently high, enabling to provide the closed loop damping from clamping piezo to shear piezo according to the present invention over a practically usable dynamic range.

Referring to Figure 7 and the description to Figure 7, in an embodiment, piezo motor system comprises a further first piezo configured to exert a further first actuator force in the first direction and a further second piezo configured to exert a further second actuator force in the second direction,
wherein the one of the further first piezo and the further second piezo is configured to actuate the other one of the further first piezo and the further second piezo and
wherein the other one of the further first piezo and the further second piezo is configured to actuate the object, and
wherein the controller is configured to
   - detect from the further first piezo a further electric signal representative of a force on the further first piezo in the second direction, and
   - apply damping control for the piezo motor system using the further second piezo based on the detected further electric signal,
wherein the controller is configured to in turn
   - actuate the first piezo and the second piezo to interact with the object, and
   - actuate the further first piezo and the further second piezo to interact with the object.

Referring to Figure 7 and the corresponding description, the first piezo and second piezo may be comprised in the first group, while the further first piezo and the further second piezo may be comprised in the second group, enabling to provide a stepper motor.

In an embodiment, the first piezo and the second piezo each comprise plural piezo actuator parts, e.g. arranged in parallel to position the object. As described above, the damping control may be performed by detecting from a first piezo actuator part of the first piezo an electric signal representative of a force on the first piezo actuator part in the second direction, and apply damping control for the piezo motor system using the second piezo actuator part based on the detected electric signal. For example, the first piezo actuator part from which the signal is detected and the second piezo actuator part which is used in the damping control based on the detected electric signal may be in a same stack of first and second piezo actuator parts, i.e. the first and second piezo actuator parts, used in the detection of the electric signal and in the damping control, being stacked to exert forces onto each other. In another example, the first piezo actuator part from which the signal is detected and the second piezo actuator part which is used in the damping control based on the detected electric signal may be in differnt stacks of first and second piezo actuator parts.

According to a further embodiment, there is provided a projection system for an exposure apparatus, comprising the piezo motor system according to the invention. The object may comprise an optical element, such as a projection lens, of the projection system. The piezo motor system may accordingly be configured to position the optical element, such as the projection lens, of the projection system.

According to a yet further embodiment, there is provided an exposure apparatus comprising the piezo motor system according to the invention or the projection system according to the invention.

According to a still further embodiment, there is provided a method of controlling a piezo motor system comprising for positioning an object, the piezo motor system comprising a first piezo and a second piezo, wherein
- the first piezo is configured to exert a force in a first direction,
- the second piezo is configured to exert a force in a second direction,
   wherein the second direction is different from the first direction,
   wherein one of the first piezo and the second piezo is configured to actuate the other one of the first piezo and the second piezo and the other one of the first piezo and the second piezo is configured to actuate the object, and
- wherein the method comprises
   - detecting from the first piezo an electric signal representative of a force in the second direction, and
   - applying damping control for the piezo motor system using the second piezo based on the detected electric signal.

According to a yet still further embodiment, there is provided a manufacturing method for manufacturing a semiconductor item, comprising exposing a substrate to a radiation using the exposure apparatus according to the invention, developing the exposed substrate, and manufacturing a semiconductor item from the developed substrate.

With the projection system, the exposure apparatus, the method of controlling and the manufacturing method, the same or similar effects and advantages may be achieved as with the described piezo motor system. Likewise, the same or similar embodiments, as described with reference to said piezo motor system.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting.

## Claims

1. A piezo motor system for positioning an object, the piezo motor system comprising a first piezo, a second piezo, and a controller, wherein
- the first piezo is configured to exert a first piezo force in a first direction,
- the second piezo is configured to exert a second piezo force in a second direction,
the second direction is different from the first direction,
one of the first piezo and the second piezo is configured to actuate the other one of the first piezo and the second piezo and the other one of the first piezo and the second piezo is configured to actuate the object, and
- the controller is configured to
- detect from the first piezo an electric signal representative of a force on the first piezo in the second direction, and
- apply damping control for the piezo motor system using the second piezo based on the detected electric signal.

2. The piezo motor system according to claim 1, wherein the electric signal is a piezo crystal voltage or a piezo charge signal of the first piezo.

3. The piezo motor system according to claim 1 or 2, wherein the controller is configured to derive a damping control signal from the electric signal and to add the damping control signal from the first piezo to an actuation signal of the second piezo.

4. The piezo motor system according to any one of the preceding claims, wherein the controller is configured to apply damping control for the piezo motor system using the second piezo.

5. The piezo motor system according to any one of the preceding claims, wherein the controller is configured to control the second piezo according to a setpoint signal and to combine the setpoint signal with the electric signal.

6. The piezo motor system according to any one of the preceding claims, wherein the second direction is perpendicular to the first direction.

7. The piezo motor system according to any one of the preceding claims, wherein the first piezo comprises a clamp piezo and wherein the first piezo force in the first direction comprises a clamping force.

8. The piezo motor system according to any one of the preceding claims, wherein the second piezo comprises a shear piezo and wherein the second piezo force in the second direction comprises a shear force.

9. The piezo motor system according to any one of the preceding claims, wherein the first piezo is configured to actuate the second piezo and wherein the second piezo is configured to actuate the object.

10. The piezo motor system according to any one of the preceding claims, comprising a further first piezo configured to exert a further first actuator force in the first direction and a further second piezo configured to exert a further second actuator force in the second direction,
wherein the one of the further first piezo and the further second piezo is configured to actuate the other one of the further first piezo and the further second piezo and
wherein the other one of the further first piezo and the further second piezo is configured to actuate the object, and
wherein the controller is configured to
- detect from the further first piezo a further electric signal representative of a force on the further first piezo in the second direction, and
- apply damping control for the piezo motor system using the further second piezo based on the detected further electric signal,
wherein the controller is configured to in turn
- actuate the first piezo and the second piezo to interact with the object, and
- actuate the further first piezo and the further second piezo to interact with the object.

11. A projection system for an exposure apparatus, comprising the piezo motor system according to any one of the preceding claims.

12. The projection system according to claim 11, wherein the object comprises an optical element of the projection system.

13. An exposure apparatus comprising the piezo motor system according to any one of claims 1 to 10 or the projection system according to any one of claims 11 - 12.

14. A method of controlling a piezo motor system comprising for positioning an object, the piezo motor system comprising a first piezo and a second piezo, wherein
- the first piezo is configured to exert a force in a first direction,
- the second piezo is configured to exert a force in a second direction,
wherein the second direction is different from the first direction,
wherein one of the first piezo and the second piezo is configured to actuate the other one of the first piezo and the second piezo and the other one of the first piezo and the second piezo is configured to actuate the object, and
- wherein the method comprises
- detecting from the first piezo an electric signal representative of a force in the second direction, and
- applying damping control for the piezo motor system using the second piezo based on the detected electric signal.

15. A manufacturing method for manufacturing a semiconductor item, comprising exposing a substrate to a radiation using the exposure apparatus according to claim 13, developing the exposed substrate, and manufacturing a semiconductor item from the developed substrate.
